# EUROPEAN PATENT SPECIFICATION

(11) **EP 3 817 075 B1**
(45) Date of publication and mention of the grant of the patent: **10.08.2022**
(21) Application number: 19465584.1
(22) Date of filing: 29.10.2019
(51) Int. Cl.: H01L 41/053, B06B 1/06, H01L 41/187, H01L 41/313, H04R 17/00

(54) **PIEZOCERAMIC ULTRASONIC TRANSDUCER**
PIEZOKERAMISCHES ULTRASCHALLWANDLERELEMENT
TRANSDUCTEUR ULTRASONIQUE EN CÉRAMIQUE PIÉZOÉLECTRIQUE

(43) Date of publication of application: 05.05.2021
(73) Proprietor: Continental Automotive Technologies GmbH, 30165 Hannover (DE)
(72) Inventor: Dulf, Andrei, 81737 München (DE)
(74) Representative: Continental Corporation

(56) References cited:
- WO-A1-96/25244
- DE-A1-102016 205 070
- US-A- 5 442 150

## Description

The present invention relates to a piezoceramic ultrasonic transducer for a vehicle. Piezoceramic ultrasonic transducers are often used for distance measurements, for example in air springs, but also for distance measuring systems in vehicles. They usually use a disc-shaped piezoceramic oscillator. This piezoceramic oscillator, when excited by an electric field, produces mechanical vibrations which generate ultrasonic waves as known to a person skilled in the art. These ultrasonic waves are then used for distance measurements as known to a person skilled in the art. Once the piezoceramic oscillator oscillates (for generating ultrasonic waves), the piezoceramic oscillator, however, also transmits mechanical vibrations to, for example, the printed circuit board (PCB) which provides the energy to the oscillator. In order to minimize a mechanical coupling between the (vibrating) piezoceramic oscillator and its environment, in particular the PCB, an elastomeric element which includes some viscoelasticity is mounted between the piezoceramic oscillator and the PCB for dampening and mechanically decoupling vibrations transmitted from the piezoceramic oscillator to the PCB. In addition, electrical connections between the piezoceramic oscillator and the PCB are often implemented as extremely thin wires to minimize any mechanical vibratory coupling between the piezoceramic oscillator and the PCB. These extremely thin wires usually also extend through elastomeric element. Known devices are disclosed by WO 96 / 25244 A1, US 5 442 150 and DE 10 2016 205 070 A1. None of them comprises the specific combination of a piezoceramic with a two component elastomeric element as defined by independent claim 1.

One problem with these elastomeric elements is, however, that the quality of mechanical vibratory decoupling largely depends on the temperatures in which the piezoceramic oscillator works. If, for example, the temperature is very low, the elastomeric element may become hard and therefore the mechanical decoupling between the oscillator and the PCB gets worse. As a result, the PCP may start vibrating, potentially emit noise signals which basically reduce the signal-to-noise ratio of the piezoceramic ultrasonic transducer. Moreover, in some extreme cases, a solid and long-lasting bonding between the piezoceramic oscillator and the PCB can no longer be guaranteed due to the increased hardness of the elastomeric element.

The object of the present invention, therefore, is to provide a piezoceramic ultrasonic transducer for a vehicle, which is capable of operating in a wide range of temperature ranges without a significant loss in performance and which provides for a long-lasting support of the oscillator on the PCB.

The object is solved by a piezoceramic ultrasonic transducer according to claim 1. Further advantages and developments are given in the dependent claims.

According to an aspect of the present invention, a piezoceramic ultrasonic transducer for a vehicle is disclosed. The piezoceramic ultrasonic transducer includes a disc-shaped piezoceramic oscillator for generating ultrasonic waves, a printed circuit board (PCB) for providing electric power to the disc-shaped piezoceramic oscillator and a composite elastomeric element arranged between the disc-shaped piezoceramic oscillator and the printed circuit board for supporting the piezoceramic oscillator on the printed circuit board. According to the invention, the composite elastomeric element includes a first elastomeric compound element and a second elastomeric compound element, wherein the first elastomeric compound element includes a first temperature dependent viscoelasticity and supports the piezoceramic oscillator on the printed circuit board in a first temperature range and the second elastomeric compound element includes a second temperature dependent viscoelasticity different from the first temperature dependent viscoelasticity and supports the piezoceramic oscillator on the printed circuit board in a second temperature range which is different from the first and temperature range.

The present invention is at least partially based on the idea that by using two different temperature-dependent elastomeric compound elements, at least one of the two elastomeric compound elements provides a solid and long-lasting support for the piezoceramic oscillator on the PCB as well as a good-enough mechanical vibratory decoupling between the oscillator and the PCB over the respective temperature range.

Within the meaning of this disclosure, the wording "support on the PCB" means that during the first temperature range predominantly the first elastomeric compound element provides the support to the PCB, whereas during the second temperature range, the second elastomeric compound element predominantly provides the support on the PCB.

So for example, during a low temperature range, for example, the first elastomeric compound element still has enough viscoelasticity such that a mechanical vibratory decoupling between the vibrating piezoceramic oscillator and the PCB is predominantly ensured by the first elastomeric compound element. Conversely, during a high-temperature range, for example, the second elastomeric compound element still has enough viscoelasticity such that a mechanical vibratory decoupling between the vibrating piezoceramic oscillator and the PCB is predominantly ensured by the second elastomeric compound element.

According to an embodiment of the present invention, the first elastomeric compound element and the second elastomeric compound element are arranged alternately within the composite elastomeric element. Thus, either during high temperature ranges or low temperature ranges alternately one of the two elastomeric compound elements can provide a good mechanical vibratory decoupling between the oscillator and the PCB as well as a long-lasting and solid support for the oscillator.

In a preferred embodiment the composite elastomeric element has a disc-shaped main body and the first elastomeric element and the second elastomeric compound element - which are arranged alternately - are concentric annular elements with different diameters. In this preferred embodiment, at least one of the two elastomeric compound elements provides for an annular support surface for the disc-shaped piezoceramic oscillator. The advantage of providing an annular support surface is that vibrations of the piezoceramic oscillator are evenly distributed among the annular support surface and therefore any tilting of the oscillator can be minimised for any of the two temperature ranges.

For example, if the piezoceramic ultrasonic transducer is operated within a low-temperature range and the first elastomeric compound element is selected such that it has good viscoelasticity for supporting the piezoceramic oscillator within the low-temperature range, due to the annular support surface, any tilting of the oscillator can be minimised within the low-temperature range. Conversely, if the piezoceramic ultrasonic transducers is operated within a high-temperature range and the second elastomeric compound element is selected such that it has good viscoelasticity for supporting the piezoceramic oscillator within the high-temperature range, due to the annular support surface, any tilting of the oscillator can be minimised within the high-temperature range.

According to a further embodiment of the present invention, the first temperature range is in a range of about -40°C to about +20°C and the second temperature range is in a range of about +20°C to about 90°C. In this further embodiment, the first elastomeric compound element is selected such that first elastomeric compound element includes a first temperature dependent viscoelasticity for predominantly supporting the piezoceramic oscillator within the first temperature range and the second elastomeric compound element of selected such that the second elastomeric compound element includes a second temperature dependent viscoelasticity for predominantly supporting the piezoceramic oscillator within the second temperature range.

Exemplary embodiments of the invention are described by the accompanying drawings, which are incorporated herein and constitute a part of the specification. In the drawings:
FIG 1 is a schematic view of a piezoceramic ultrasonic transducer according to a first embodiment of the present invention,
FIG 2 is a schematic cross-sectional view along line A-A of the piezoceramic ultrasonic transducer of FIG 1, and
FIG 3 is a schematic cross-sectional view of another embodiment of a piezoceramic ultrasonic transducer according to the present invention.

Within this disclosure, the same reference numbers refer to the same components.

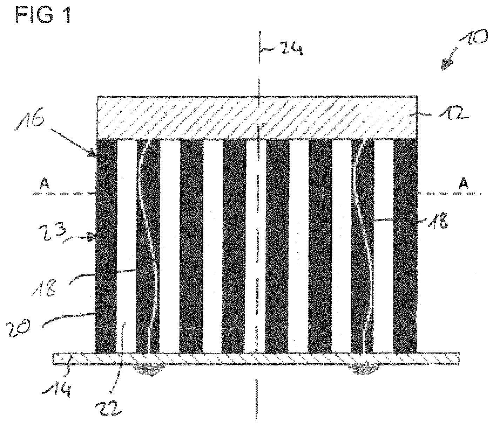

FIG 1 shows a schematic view of a piezoceramic ultrasonic transducer 10 of a first embodiment of the present invention. The piezoceramic ultrasonic transducer 10 may be used for distance measurements, for example in air springs, but also for distance measuring systems in vehicles.

The piezoceramic ultrasonic transducer 10 includes a disc-shaped piezoceramic oscillator 12 for generating ultrasonic waves and a printed circuit board (PCB) 14 for providing electric power to the piezoceramic oscillator 12. The piezoceramic ultrasonic transducer 10 further includes a composite elastomeric element 16 which is arranged between the oscillator 12 and the PCB 14 for supporting the oscillator 12 on the PCB 14. Electrical connections 18 are provided within composite elastomeric element 16 for electrical connecting the oscillator 12 with the PCB 14. These electrical connections 18 may be for example very thin wires.

As can be seen in FIG 1, the composite elastomeric element 16 includes two elastomeric compound elements. A first elastomer compound element 20 is arranged next to a second elastomeric compound 22. The first elastomeric compound element 20 is selected such that it includes a first temperature dependent viscoelasticity and provides a main support for the oscillator 12 on the PCB 14 in a first temperature range, for example, in range between about -40°C to about +20°C. Therefore, the first elastomeric compound element 20 may also be referred to as "low-temperature elastomeric compound element". The second elastomeric compound element 22 is selected such that it includes a second temperature dependent viscoelasticity and provides a main support for the oscillator 12 on the PCB 14 in a second temperature range, for example, in a range between about +20°C to about +90°C. Therefore, the second elastomeric compound element 22 may also be referred to as "high-temperature elastomeric compound element". For this, the low-temperature elastomeric compound element 20 may be made of a different material or different material composition than the high temperature elastomeric compound element 22.

As can be further seen in FIG 1, the first and second elastomeric compound elements 20, 22 are arranged alternately within composite elastomeric element 16. Thus, composite elastomeric element 16 comprises alternating sections of low- and high-temperature elastomeric compound elements 20, 22. The number of alternating sections of low- and high-temperature elastomeric compound elements 20, 22 can be adapted to the application at hand. Also, the composite elastomeric element 16 includes a disc-shaped main body 23 extending in an axial direction along an axis 24 and extending in a radial direction perpendicular to axis 24. Thus, depending on the application at hand, also the height (measured in axial direction of the disc-shaped main body 23) of the disc-shaped main body 23 as well as the thickness (measured along the radial direction of disc-shaped main body 23) of each section of low- and high-temperature elastomeric compound elements 20, 22 can be adapted.

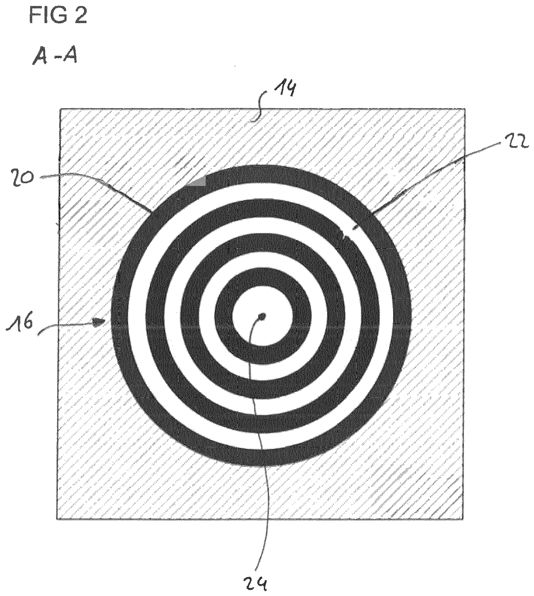

Referring now to FIG 2, a schematic cross-sectional view of piezoceramic ultrasonic transducer 10 of FIG 1 along line A-A is shown.

As can be seen, both first and second elastomeric compound elements 20, 22 are concentric annular elements with different diameters (measured in a radial direction of disc-shaped main body 23, i.e. in a direction perpendicular to axis 24). Thus, either the low-temperature elastomeric compound element 20 or the high-temperature elastomeric compound element 22 provides an annular support surface for supporting oscillator 12 on PCB 14 in the respective low- or high-temperature range.

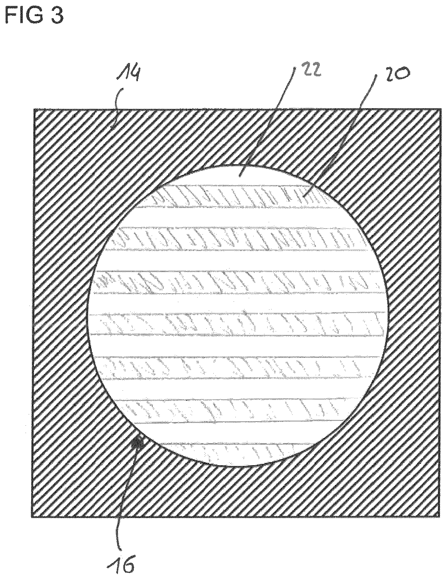

Referring now to FIG 3, a schematic cross-sectional view of another embodiment of piezoceramic ultrasonic transducer 10 of FIG 1 along line A-A is shown.

As can be seen, in the piezoceramic ultrasonic transducer 10 according to FIG 3, low- and high-temperature elastomeric compound elements 20, 22 are not concentric annular elements with different diameters (as shown in FIG 2), but alternating columns or pillars. The embodiment shown in FIG 3 is another example for alternately arranged low- and high-temperature elastomeric compound elements 20, 22. Further appropriate embodiments of alternately arranged low- and high-temperature elastomeric compound elements 20, 22 are conceivable, depending on the application at hand.

The piezoceramic ultrasonic transducer 10 according to the present invention ensures a reliable performance over low- and high-temperature ranges by having a composite elastomeric element with low- and high-temperature elastomeric compound elements. Moreover, as low- and high-temperature elastomeric compound elements are selected such that the respective temperature dependent viscoelasticities are best within either the low- or the high-temperature range, a long-lasting and reliable support of the oscillator 12 on the PCB 14 as well as a good mechanical vibratory decoupling between the oscillator 12 and the PCB 14 are ensured.

Although only two different (i.e. a low- and a high-temperature) elastomeric compound elements are shown in connection with FIGs 1 to 3, it is conceivable that composite elastomeric element 16 may include more than two different elastomeric compound elements. For example, in other embodiments not shown, composite elastomeric element 16 may include three or more different elastomeric compound elements which each have a different temperature dependent viscoelasticity suited to the application at hand.

## Claims

1. A piezoceramic ultrasonic transducer (10) for a vehicle, comprising:
- a disc-shaped piezoceramic oscillator (12) for generating ultrasonic waves;
- a printed circuit board (14) for providing electric power to the disc-shaped piezoceramic oscillator (12), and
- a composite elastomeric element (16) arranged between the disc-shaped piezoceramic oscillator (12) and the printed circuit board (14) for supporting the piezoceramic oscillator (12) on the printed circuit board (14), wherein the composite elastomeric element (16) includes a first elastomeric compound element (20) and a second elastomeric compound element (22), wherein the first elastomeric compound element (20) includes a first temperature dependent viscoelasticity and supports the piezoceramic oscillator (12) on the printed circuit board (14) in a first temperature range and the second elastomeric compound element (22) includes a second temperature dependent viscoelasticity and supports the piezoceramic oscillator (12) on the printed circuit board (14) in a second temperature range different from the first temperature range.

2. The piezoceramic ultrasonic transducer (10) of claim 1, wherein the first elastomeric compound element (20) and the second elastomeric compound element (22) are arranged alternately.

3. The piezoceramic ultrasonic (10) transducer of claim 2, wherein the composite elastomeric element (16) has a disc-shaped main body (23) and the first elastomeric compound element (20) and the second elastomeric compound element (22) are concentric annular elements with different diameters.

4. The piezoceramic ultrasonic transducer (10) of any one of the preceding claims, wherein the first temperature range is in a range of about -40°C to about +20°C, and the second temperature range is in a range of about +20°C to about +90°C.

## Patentansprüche

1. Piezokeramischer Ultraschallwandler (10) für ein Fahrzeug, aufweisend:
- einen scheibenförmigen piezokeramischen Oszillator (12) zum Erzeugen von Ultraschallwellen;
- eine Leiterplatte (14) zum Liefern elektrischer Leistung an den scheibenförmigen piezoelektrischen Oszillator (12), und
- ein zusammengesetztes elastomeres Element (16), angeordnet zwischen dem scheibenförmigen piezoelektrischen Oszillator (12) und der Leiterplatte (14) zum Unterstützen des piezokeramischen Oszillators (12) auf der Leiterplatte (14), wobei das zusammengesetzte elastomere Element (16) ein erstes Element (20) aus einer elastomeren Verbindung und ein zweites Element (22) aus einer elastomeren Verbindung enthält, wobei das erste Element (20) aus einer elastomeren Verbindung eine erste temperaturabhängige Viskoelastizität enthält und den piezokeramischen Oszillator (12) auf der Leiterplatte (14) in einem ersten Temperaturbereich unterstützt und das zweite Element (22) aus einer elastomeren Verbindung eine zweite temperaturabhängige Viskoelastizität enthält und den piezokeramischen Oszillator (12) auf der Leiterplatte (14) in einem von dem ersten Temperaturbereich verschiedenen zweiten Temperaturbereich unterstützt.

2. Piezokeramischer Ultraschallwandler (10) nach Anspruch 1, wobei das erste Element (20) aus einer elastomeren Verbindung und das zweite Element (22) aus einer elastomeren Verbindung abwechselnd angeordnet sind.

3. Piezokeramischer Ultraschallwandler (10) nach Anspruch 2, wobei das zusammengesetzte elastomere Element (16) einen scheibenförmigen Hauptkörper (23) aufweist und das erste Element (20) aus einer elastomeren Verbindung und das zweite Element (22) aus einer elastomeren Verbindung konzentrische ringförmige Elemente mit unterschiedlichen Durchmessern sind.

4. Piezokeramischer Ultraschallwandler (10) nach einem der vorhergehenden Ansprüche, wobei der erste Temperaturbereich in einem Bereich von etwa -40 °C bis etwa +20 °C liegt und der zweite Temperaturbereich in einem Bereich von etwa +20 °C bis etwa +90 °C liegt.

## Revendications

1. Transducteur ultrasonore en céramique piézoélectrique (10) pour un véhicule, comprenant :
- un oscillateur en céramique piézoélectrique en forme de disque (12) pour générer des ondes ultrasonores ;
- une carte de circuit imprimé (14) pour fournir de l'énergie électrique à l'oscillateur en céramique piézoélectrique en forme de disque (12) ; et
- un élément élastomère composite (16) disposé entre l'oscillateur en céramique piézoélectrique en forme de disque (12) et la carte de circuit imprimé (14) pour supporter l'oscillateur en céramique piézoélectrique (12) sur la carte de circuit imprimé (14), l'élément élastomère composite (16) comportant un premier élément en composé élastomère (20) et un deuxième élément en composé élastomère (22), le premier élément en composé élastomère (20) présentant une première viscoélasticité dépendante de la température et supportant l'oscillateur en céramique piézoélectrique (12) sur la carte de circuit imprimé (14) dans une première gamme de températures et le deuxième élément en composé élastomère (22) présentant une deuxième viscoélasticité dépendante de la température et supportant l'oscillateur en céramique piézoélectrique (12) sur la carte de circuit imprimé (14) dans une deuxième gamme de températures différente de la première gamme de températures.

2. Transducteur ultrasonore en céramique piézoélectrique (10) de la revendication 1, dans lequel le premier élément en composé élastomère (20) et le deuxième élément en composé élastomère (22) sont disposés en alternance.

3. Transducteur ultrasonore en céramique piézoélectrique (10) de la revendication 2, dans lequel l'élément élastomère composite (16) a un corps principal en forme de disque (23) et le premier élément en composé élastomère (20) et le deuxième élément en composé élastomère (22) sont des éléments annulaires concentriques avec différents diamètres.

4. Transducteur ultrasonore en céramique piézoélectrique (10) de l'une quelconque des revendications précédentes, dans lequel la première gamme de températures se situe dans une gamme d'environ -40 °C à environ +20 °C, et la deuxième gamme de températures se situe dans une gamme d'environ +20 °C à environ +90 °C.
